# EUROPEAN PATENT APPLICATION

(11) **EP 2 981 049 A1**
(43) Date of publication of application: **03.02.2016**
(21) Application number: 14772695.4
(22) Date of filing: 27.03.2014
(51) Int. Cl.: H04M 1/02, H05K 5/02, H05K 5/06

(54) **WATERPROOF STRUCTURE HAVING ILLUMINATION FUNCTION**

(30) Priority: 28.03.2013 JP 2013068635
(71) Applicant: NEC CORPORATION, Tokyo 108-8001 (JP)
(72) Inventor: SHIOGAMA, Naoki, Kawasaki-shi Kanagawa 211-8666 (JP)
(74) Representative: Vossius & Partner Patentanwälte Rechtsanwälte mbB
(86) International application number: PCT/JP2014/058825
(87) International publication number: WO 2014/157504

(57) **Abstract**

To provide a water proof structure enabling a device to provide water proof property and uniform and even illumination function in an integrated manner. A water proof structure in which a water proof gasket is arranged between a housing case and a housing cover, the water proof gasket is made of a light permeable material; and at least one light entrance portion is arranged to respective sides opposing each other, of the water proof gasket; and at least one portion of the water proof gasket is exposed to outside of the housing.

## Description

### TECHNICAL FIELD

### (DESCRIPTION OF RELATED APPLICATION)

This invention claims the benefit of Japanese Patent Application No. 2013-068635, filed March 28, 2013. The entire disclosure thereof is incorporated herein by reference thereto. The present invention relates to a water proof structure providing both water proof property and uniform illumination function that enables to be used for mobile devices including cellular phone.

### BACKGROUND

As for recent, mobile devices including cellular phone usage is envisaged under various situations with the advent of ubiquitous society of whenever, wherever and with whomever. Usage scene at water areas is also envisaged as one of the situations using them, and products providing water proof property have been announced one after another. In addition, illumination function is often required as a function for product differentiation, and the illumination function is also highly required in a water proof model.

For example, in Patent Literature 1, it is disclosed that a seal structure comprising a transparent or semi-transparent frame shape seal member extending along an outer periphery of housing and, a light source element arranged within a hermetic sealing area of this seal member. In this state, light emitted from the light source element is taken into the interior of the seal member, and at least a portion of the seal member is caused to emit light (see Patent Literature 1).

### CITATION LIST

### PATENT LITERATURE

### [PATENT LITERATURE 1]

International Publication WO 2012/053269

### SUMMARY

### TECHNICAL PROBLEM

The analysis described below is provided by the inventor of the present invention.

However, in a seal structure disclosed in Patent Literature 1, a light entrance portion of light from a light emitting means is arranged only at one side of a seal member. Therefore, it is difficult for the light emitted from the light emitting means to guide uniformly to portions distal from the light entrance portion of the seal member (for example, a portion on an opposite side of the light entrance portion in a frame shape). There was a problem in that esthetic appearance is markedly impaired because light emission degree gets uneven in this distal portion such that, for example, light emission becomes weak due to light attenuation.

It is a technical problem of the present invention to provide a water proof structure enabling a device to provide water proof property and uniform and even illumination function in an integrated manner, and it can be used for mobile devices including cellular phone.

### SOLUTION TO PROBLEM

According to an aspect of the present invention, there is provided a water proof structure in which a water proof gasket is arranged between a housing case and a housing cover, the water proof gasket is made of a light permeable material; and at least one light entrance portion is arranged to respective sides opposing each other, of the water proof gasket; and at least one portion of the water proof gasket is exposed to outside of the housing.

### ADVANTAGEOUS EFFECTS OF INVENTION

A water proof structure according to the present invention contributes to provide water proof property and a uniform illumination function to a device in which this water proof structure is used, by providing the uniform illumination function to a water proof gasket.

### BRIEF DESCRIPTION OF THE DRAWINGS

Fig. 1 is a schematic perspective view of a device providing a water proof structure according to a first exemplary embodiment (herein it is a foldable cellular phone);
Fig. 2 is a schematic exploded perspective view of the water proof structure according to the first exemplary embodiment;
Fig. 3 is a schematic external view of the water proof gasket according to the first exemplary embodiment, as viewed from a direction of a housing case;
Fig. 4 is an exploded cross sectional view of the water proof structure according to the first exemplary embodiment, taken along a line A-A' of Fig. 2;
Fig. 5 is a cross sectional view of the water proof structure according to the first exemplary embodiment, taken along a line A-A' of Fig. 1;
Fig. 6 is a cross sectional view of the water proof structure according to the first exemplary embodiment, taken along a line B-B' of Fig. 1;
Fig. 7 is a partially enlarged view of an area surrounded by a dotted line of the exploded cross sectional view of Fig. 4, in the water proof structure according to the first exemplary embodiment;
Fig. 8 is a partially enlarged view of an area surrounded by a dotted line of the cross sectional view of Fig. 6, in the water proof structure according to the first exemplary embodiment;
Fig. 9 is a schematic perspective view of a device providing a water proof structure according to a second exemplary embodiment (herein it is a foldable cellular phone);
Fig. 10 is a schematic exploded perspective view of the water proof structure according to the second exemplary embodiment;
Fig. 11 is an exploded cross sectional view of the water proof structure according to the second exemplary embodiment, taken along a line A-A' of Fig. 10;
Fig. 12 is a cross sectional view of the water proof structure according to the second exemplary embodiment, taken along a line A-A' of Fig. 9;
Fig. 13 is a cross sectional view of the water proof structure according to the second exemplary embodiment, taken along a line B-B' of Fig. 9;
Fig. 14 is a partially enlarged view of an area surrounded by a dotted line of an exploded cross sectional view of Fig. 11, in the water proof structure according to the second exemplary embodiment;
Fig.15 is a schematic exploded perspective view of a conventional water proof structure providing illumination function.

### MODES FOR CARRYING OUT THE INVENTION

First, an outline of an exemplary embodiment of the present invention will be explained with reference to the drawings. Meanwhile, reference signs in the following outline will be added to each element, as an example, for convenience to help understanding of the present invention. Thus, the reference signs are not intended to limit the present invention to the illustrated modes.

### [First exemplary embodiment]

In the following, a water proof structure according to a first embodiment is explained with reference to the drawings.

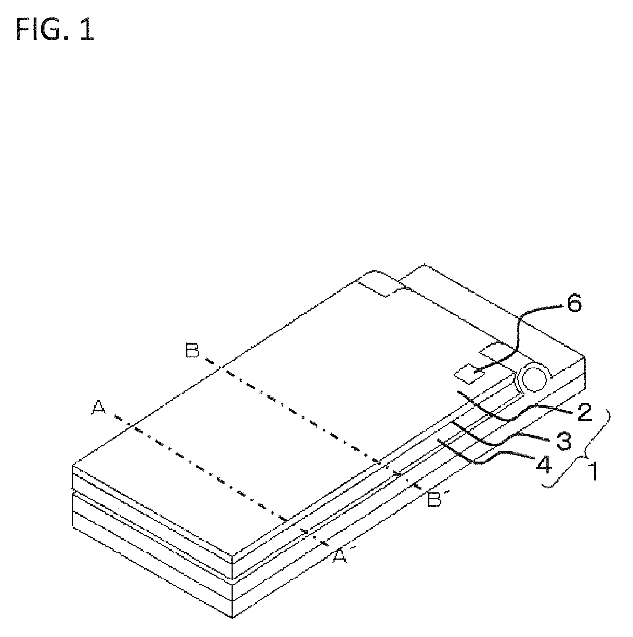

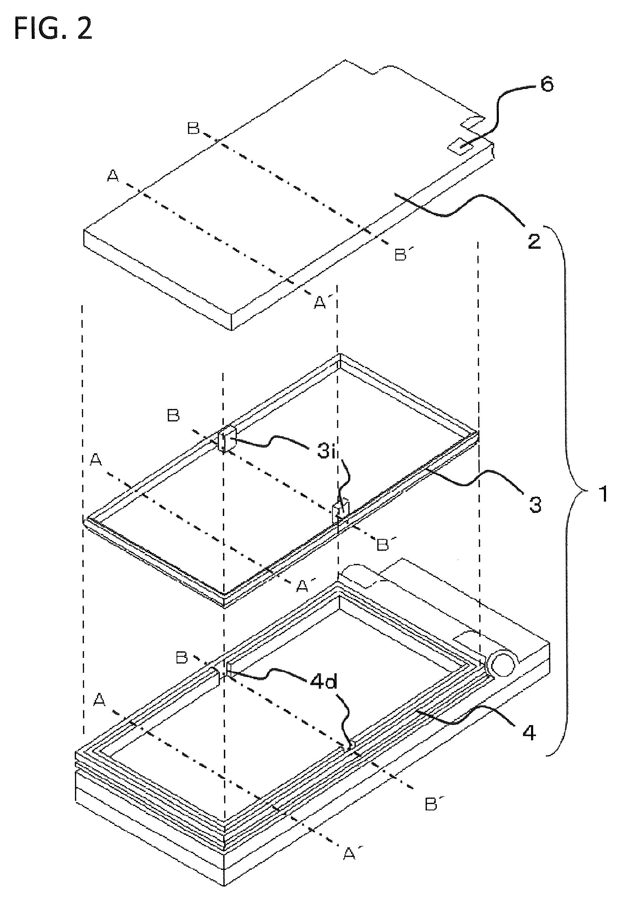

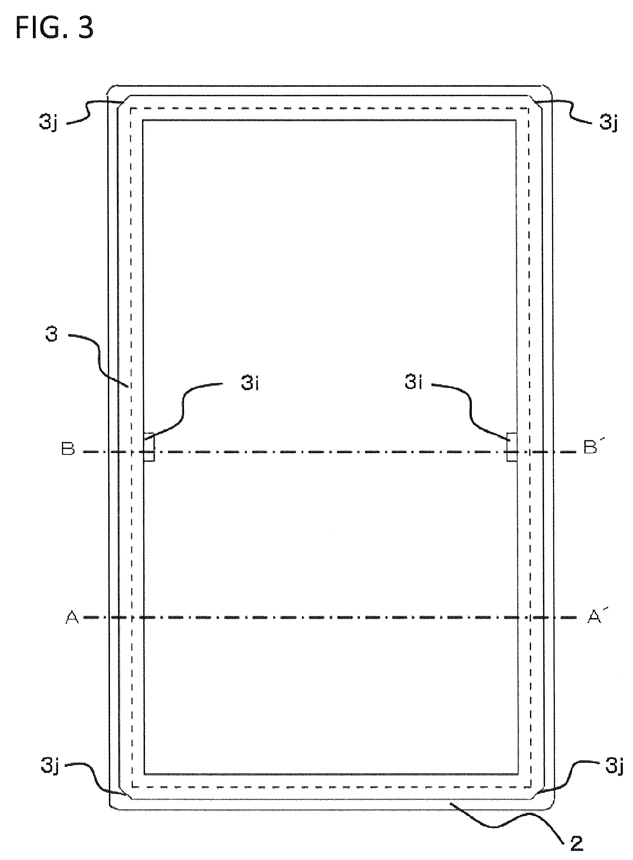

Fig. 1 shows a schematic perspective view of a device providing a water proof structure 1 according to the first exemplary embodiment (herein, as an example, a foldable cellular phone is shown). Fig. 2 shows a schematic exploded perspective view of the water proof structure 1 according to the first exemplary embodiment. In addition, Fig. 3 shows a schematic external view of a water proof gasket 3 according to the first exemplary embodiment, as viewed from a direction of a housing case 4.

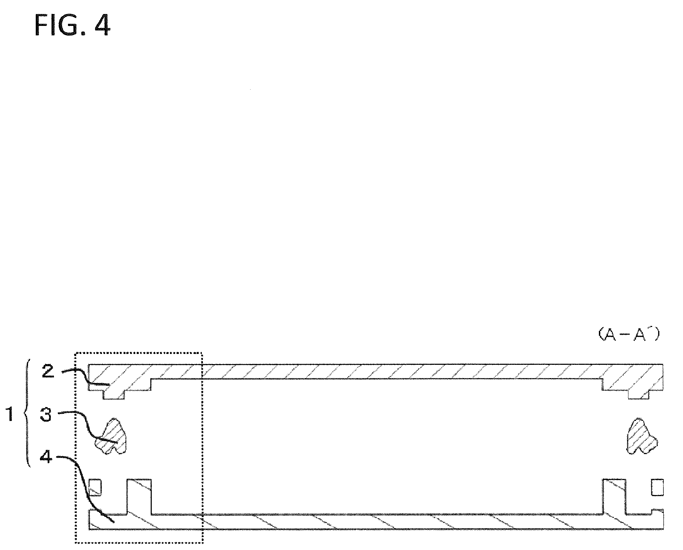

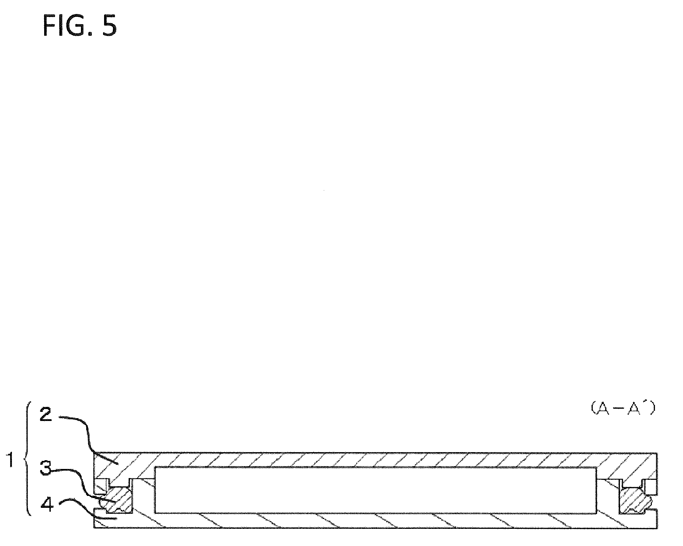

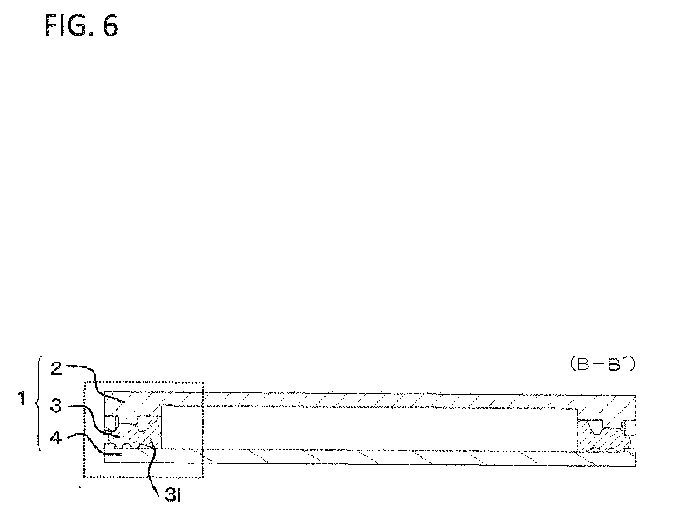

Fig. 4 shows an exploded cross sectional view of the water proof structure 1 according to the first exemplary embodiment, taken along a line A-A' of Fig. 2. Fig. 5 shows a cross sectional view of the water proof structure 1 according to the first exemplary embodiment, taken along a line A-A' of Fig. 1. Further, Fig. 6 shows a cross sectional view of the water proof structure 1 according to the first exemplary embodiment, taken along a line B-B' of Fig. 1.

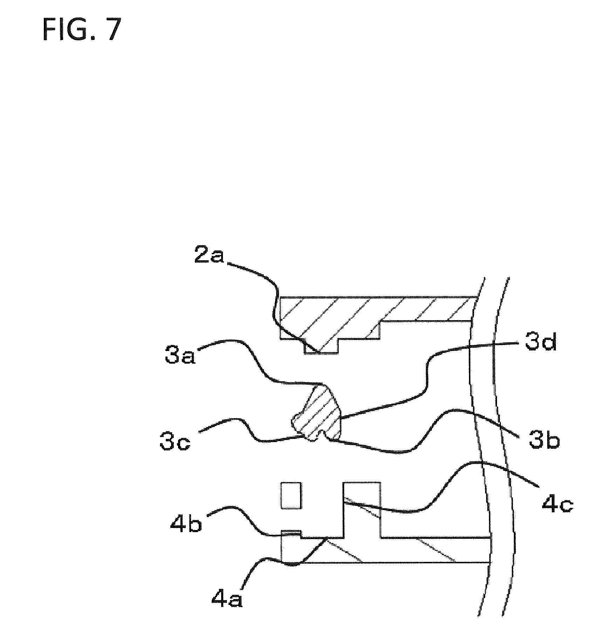

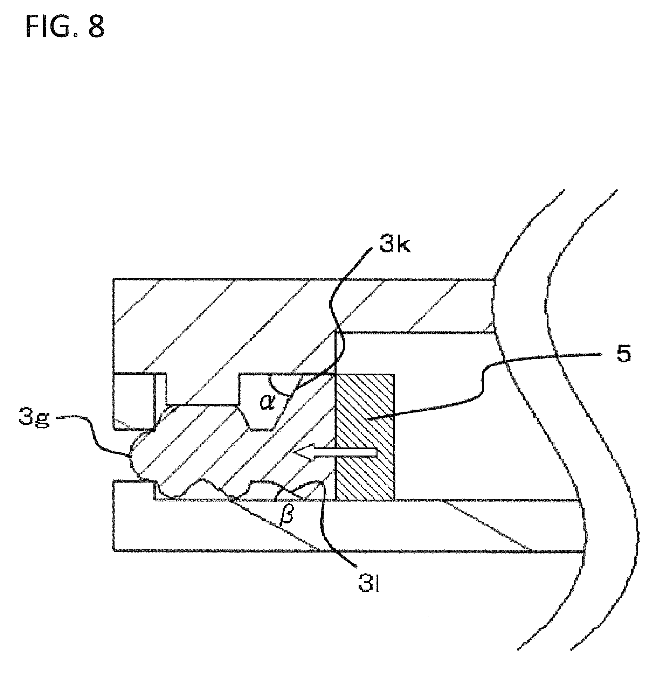

Fig. 7 shows a partially enlarged view of an area surrounded by a dotted line of the exploded cross sectional view of Fig. 4, in the water proof structure 1 according to the first exemplary embodiment. Fig. 8 shows a partially enlarged view of an area surrounded by a dotted line of the cross sectional view of Fig. 6, in the water proof structure 1 according to the first exemplary embodiment.

The water proof structure 1 can improve design of a device by that the water proof gasket 3 itself emits light uniformly, as well as water proof property can be provided to the device to which the water proof structure 1 is attached. The water proof structure 1 is mounted to mobile type electronic devices which need water proof property, such as cellular phone, smart phone and others.

The water proof structure 1 comprises a housing cover 2, the light permeable water proof gasket 3, and a housing case 4 as main components. The water proof gasket 3 is arranged so as to be sandwiched between the housing cover 2 and the housing case 4, whereby the housing is hermetically sealed. In respective sides which are opposing each other (that is, the sides which are facing each other) of the water proof gasket 3, at least one light entrance portion 3i is arranged (see Fig. 3). In addition, a portion of the water proof gasket 3 is exposed to outside of the housing, in a state in which the water proof gasket 3 is mounted to a device (for example, see Fig. 5 or Fig. 6).

The water proof gasket 3 is compressed and fitted to the housing case 4 to be retained therein. When the water proof gasket 3 is inserted into the housing case 4, while a portion exposed to outside of the housing at the time of mounting to a device (for example, a light emitting portion 3g in Fig. 8) is deformed and pressed-in, when fitting is completed, its original shape is recovered to be fixed.

Light emitted from a light emitting means 5 arranged in the housing (in figures, except for Fig. 8, the light emitting means 5 is omitted) is guided into the interior of the water proof gasket 3 through at least one light entrance portions 3i arranged to respective sides which oppose to each other, of the water proof gasket 3 (for example, in Fig. 3, one light entrance portion 3i is arranged to each one portion in the middle of the inside of the two sides (left and right sides) of the frame shape water proof gasket 3 in a projecting manner). Since the water proof gasket 3 is made of a light permeable material, light entering into the water proof gasket 3 from plural light entrance portions 3i circulates in the interior of the water proof gasket 3, whereby the entire water proof gasket 3 emits light. Since light entered from one of the light entrance portions 3i attenuates until the light reaches the opposite side thorough the interior of the water proof gasket 3, a quantity of light is compensated by light entered from the other light entrance portion(s) 3i arranged on the opposite side. Thus, the water proof gasket 3 can emit light uniformly and evenly. Since a portion of the water proof gasket 3 (the light emitting portion 3g in Fig. 8) is exposed to outside of the housing in a state in which the water proof gasket 3 is mounted to a device, the light-emitting water proof gasket 3 is visible from the outside of the housing.

A water proof gasket 3 is a member that provides elasticity made of a light permeable material to prevent water from infiltrating inside of the housing at a joint portion of the housing, and that also provides illumination function.

Although a shape of the water proof gasket 3 can be adequately changed in accordance with a shape of an area where water proof property should be secured (that is, an area inside of the water proof gasket), for example, the shape might be an oval or rectangular frame shape and others. A cross sectional shape of the water proof gasket 3 is not particularly limited as far as it is a shape in which water proof property can be secured and a portion of the water proof gasket 3 can be exposed to outside of the housing. In Fig. 7, since the water proof gasket 3 is sandwiched and compressed by the housing cover 2 and the housing case 4 to form a compression fix structure (or tightly adhere) between an (inner) top surface 2a of the housing cover 2 and a top surface 3a of the water proof gasket 3, between a bottom surface 4a of the housing case 4 and a bottom surface 3b of the water proof gasket 3, between an outer side surface 4b of the housing case 4 and a side surface of the light emitting portion 3c of the water proof gasket 3, between an inner side surface 4c of the housing case 4 and a side surface 3d of the water proof gasket 3, and between a light entrance portion fitting groove 4d and the light entrance portion 3i (see Fig. 2), respectively, a joint portion between the housing cover 2 and the housing case 4 is blocked and sealed with an elastic member, whereby reliable water preventing effect is obtained. In addition, a portion of the water proof gasket 3 (Fig. 8, the light emitting portion 3g) is exposed to outside of the housing.

In addition to providing elasticity, a transparent or semi-transparent material (that is, it provides light permeability) is used for the water proof gasket 3 in such a way that light entering from the light entrance portion 3i into the interior of the water proof gasket 3 propagates over the entire water proof gasket 3. For example, transparent or semi-transparent silicon rubber can be used.

The light emitting portion 3g of the water proof gasket 3 that is a portion exposed to outside of the housing, may provide a semi-circular cross sectional shape. Light is concentrated by this semi-circular shape likewise a convex lens, whereby brighter light can be viewed from the outside.

A reflection portion 3j providing a light reflecting surface may be arranged to a bend portion of the water proof gasket 3 (see Fig. 3, herein, the reflection portion 3j is arranged at each of four corners of the water proof gasket 3). A traveling direction of light can be controlled by reflecting light circulating in the interior of the water proof gasket 3 by the reflection portion 3j. As a result, light can be guided to the entire water proof gasket 3 effectively. Furthermore, since light can be guided to the entire water proof gasket 3 by a small number of light emitting means, reduction in the number of parts can also be achieved.

As shown in Fig. 8, a cross sectional shape of the light entrance portion 3i may provide at least one of an upper slant surface 3k at upper side (that is, a surface facing the housing cover 2) and a lower slant surface 31 at lower side (that is, a surface facing the housing case 4), and may be formed to taper converging along a traveling direction of light (in Fig. 8, a direction (axis) in which light enters into the water proof gasket 3, shown by white arrow). It is preferable that a slant angle alpha of the upper slant surface 3k has 30 to 60 degrees relative to a plane of light entering from the light emitting means 5 into the light entrance portion 3i (in Fig. 8, a plane of a white arrow direction (axis), that is, parallel to the white arrow direction). In the same way, it is preferable that a slant angle beta of the lower slant surface 31 has 30 to 60 degrees relative to a plane of light entering from the light emitting means 5 into the light entrance portion 3i (in Fig. 8, a plane of the white arrow direction (axis)). By providing these slant angles to the light entrance portion 3i, light entering into the water proof gasket 3 can be concentrated.

A resin material or a metal material can be used for the housing cover 2 and the housing case 4.

A light emitting means 5 provides light emitting function. LED and others are preferable as the light emitting means 5. In addition, the light emitting means 5 may be capable of emitting lights with different colors. An arranged portion of the light emitting means 5 is not particularly limited as far as light can be transmitted to the light entrance portion 3i of the water proof gasket 3. For example as shown in Fig. 8, the light emitting means 5 may be arranged in contact with the light entrance portion 3i.

In the present embodiment, it is possible to provide a water pressure sensor 6 at any location. For example, by detecting outside pressure as an input by the water pressure sensor 6 and incorporating a circuit in which an output is set to be an intensity of the light emission of the light emitting means 5 or a light with RGB variable colors, it is possible to provide a device that represents light change converted from water depth change (that is, change in pressure detected) by a water proof structure.

### [Second exemplary embodiment]

Hereinafter, a water proof structure according to a second exemplary embodiment will be explained by using the drawings. Meanwhile, the same components and embodiments as those in the first exemplary embodiment will be omitted.

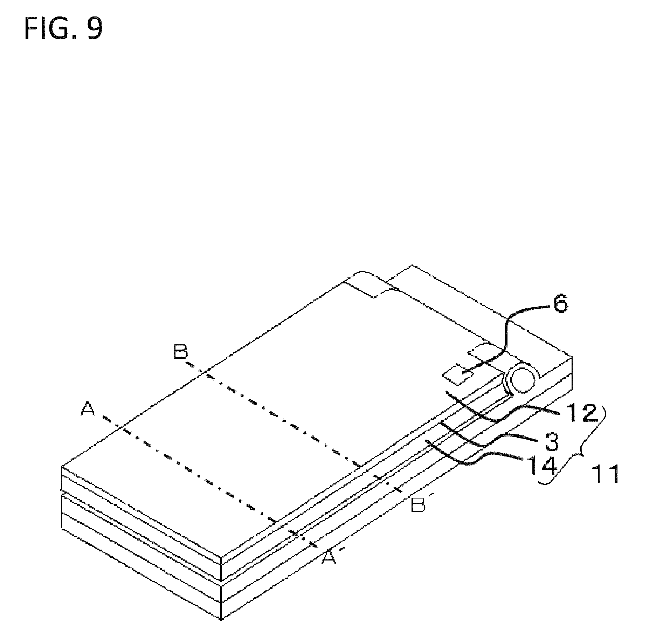

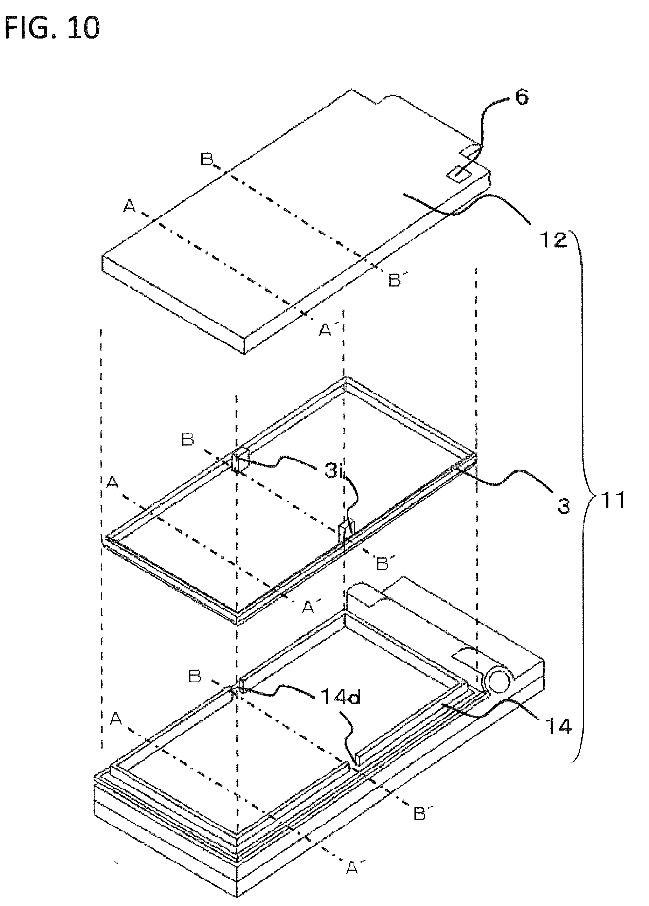

Fig. 9 shows a schematic perspective view of a device providing the water proof structure 11 according to the second exemplary embodiment (herein, as an example, a foldable cellular phone is shown). Fig. 10 shows a schematic exploded perspective view of the water proof structure 11 according to the second exemplary embodiment.

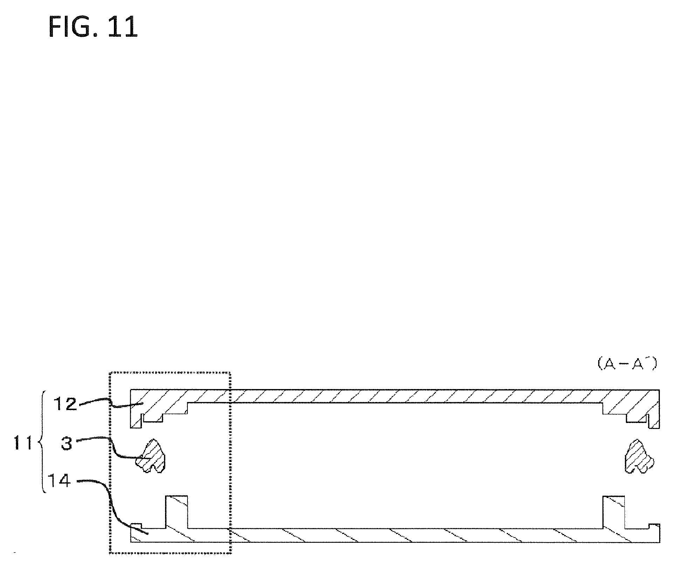

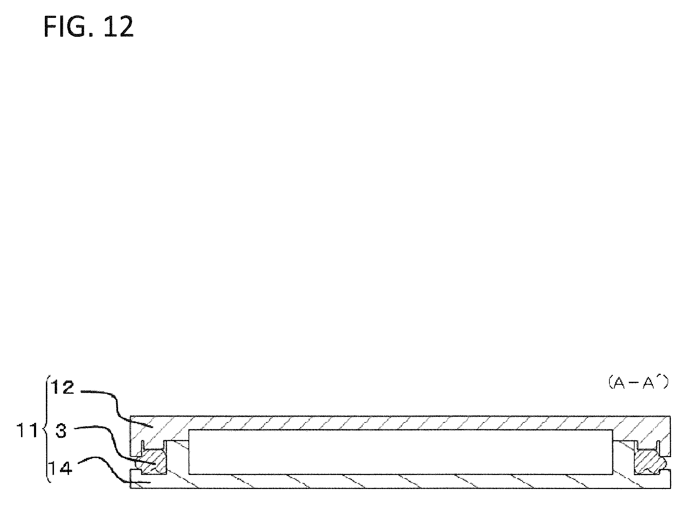

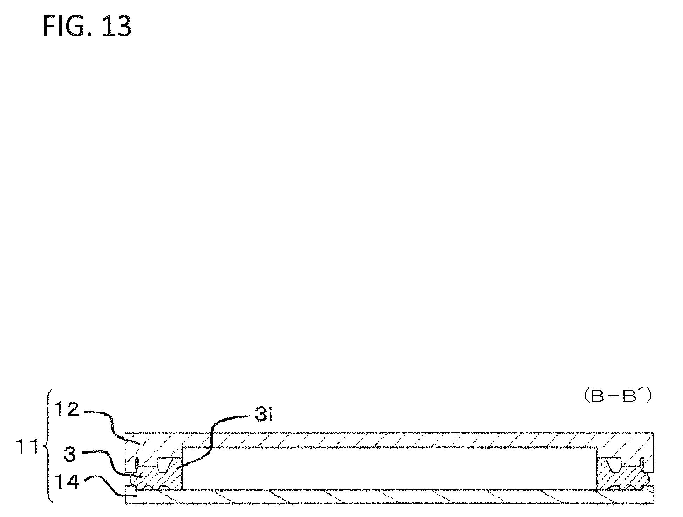

Fig. 11 shows an exploded cross sectional view of the water proof structure 11 according to the second exemplary embodiment, taken along a line A-A' of Fig. 10. Fig. 12 shows a cross sectional view of the water proof structure 11 according to the second exemplary embodiment, taken along a line A-A' of Fig. 9. Further, Fig. 13 shows a cross sectional view of the water proof structure 11 according to the second exemplary embodiment, taken along a line B-B' of Fig. 9.

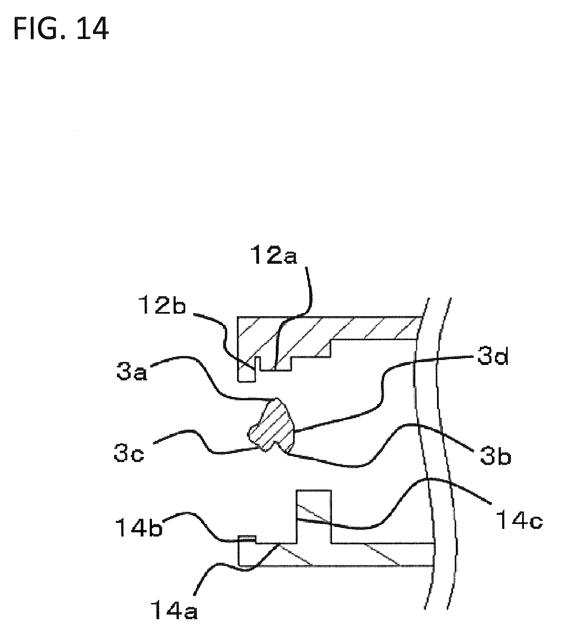

Fig. 14 shows a partially enlarged view of an area surrounded by a dotted line of the exploded cross sectional view of Fig. 11, in the water proof structure 11 according to the second exemplary embodiment.

The second exemplary embodiment is a modified example of the first exemplary embodiment, it is a structure in which upper and lower portions of the light emitting portion 3g are sandwiched by a housing cover 12 and a housing case 14 when the water proof gasket 3 is sandwiched by the housing cover 12 and the housing case 14 (see the water proof structure 11 in Figs 11 and 12). In Fig. 14, since the water proof gasket 3 is sandwiched and compressed by the housing cover 12 and the housing case 14 to form a compression fix structure between an (inner) top surface 12a of the housing cover 12 and the top surface 3a of the water proof gasket 3, between a bottom surface 14a of the housing case 14 and the bottom surface 3b of the water proof gasket 3, between an outer side surface 14b of the housing case 14 and the side surface of the light emitting portion 3c of the water proof gasket 3, between an (inner) side surface 12b of the housing cover 12 and the side surface of the light emitting portion 3c of the water proof gasket 3, between an inner side surface 14c of the housing case 14 and the side surface 3d of the water proof gasket 3, and between a light entrance portion fitting groove 14d and the light entrance portion 3i (see Fig. 10), respectively, the joint portion between the housing cover 12 and the housing case 14 is blocked and sealed with an elastic member, whereby a reliable water preventing effect is obtained. By exerting a compressive force to the water proof gasket 3, the housing cover 12 and the housing case 14 can be tightly jointed to secure water-proof. Simplification of a work involved in housing assembling can be achieved by this second exemplary embodiment, and further, the second exemplary embodiment is advantageous also in design because the joint portion (or gap) between the housing cover 12 and the housing case 14 cannot be viewed from the outside.

By adopting the water proof structure(s) according to these exemplary embodiments, a gasket for water proof and a lens for illumination can be formed and mounted as one piece. Reduction in the number of parts and downsizing of the device thereby, and further simplification of assembling process can be achieved. In addition, when a foreign object is sandwiched between the water proof gasket and the housing cover or housing case, and/or when breakage, chipping or others of a water proof gasket takes place, a shape of the light-guiding cross section of the interior of the water proof gasket is partially changed, as a result, influence on light emitted to outside of the housing will also appear. By detecting this influence, it is possible to check (or monitor) water proof function of the water proof structure and to determine replacement time of the water proof gasket.

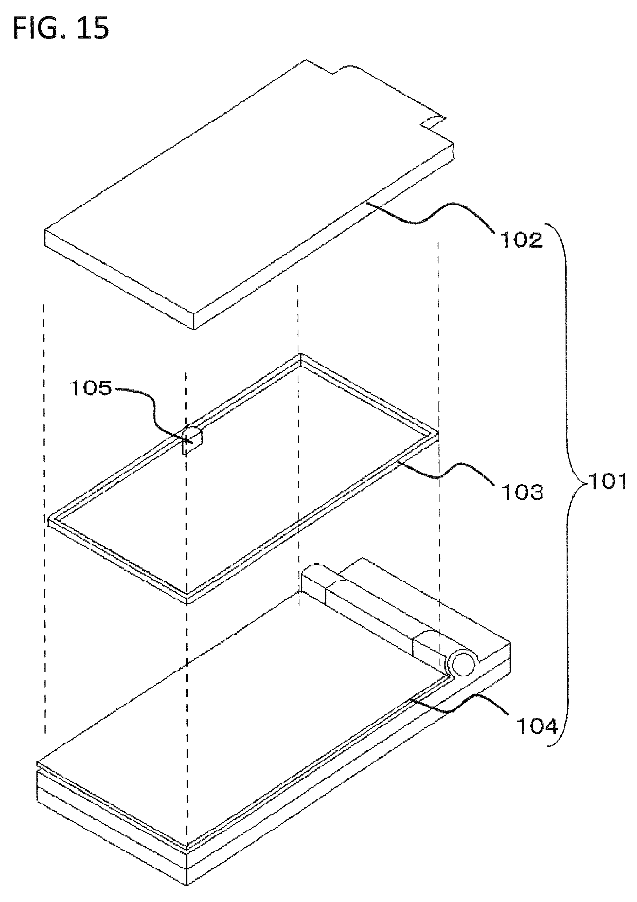

Fig. 15 shows an example of a conventional water proof structure providing illumination function. A conventional water proof structure 101 is mainly composed of a housing cover 102, a transparent or semi-transparent water proof gasket 103, and a housing case 104. The water proof gasket 103 is sandwiched between the housing cover 102 and the housing case 104, whereby the housing is hermetically sealed. A light entrance portion is arranged on one side of the frame-shaped water proof gasket 103 so as to transmit light from a light emitting means 105 arranged inside of the water proof gasket 103. Light emitted from the light emitting means 105 is transmitted through (in) the interior of the transparent or semi-transparent water proof gasket 103, whereby the water proof gasket 103 emits light.

In the Patent Literature 1, an embodiment similar to that described in Fig. 15 is disclosed. Further, in order to guide/distribute light within the water proof gasket (seal member) effectively, structures such that for example, a light emitting means is embedded in the water proof gasket, or such that a multiple layer structure is formed by the light emitting means and its wiring board, in total two light emitting means are arranged to the respective layers of an upper layer and lower layer thereof, inclined portions reflecting light to the right and left directions respectively, are arranged, are disclosed. Even though these embodiments be used, it is difficult to guide light uniformly until a portion distal from the light entrance portion of the seal member, since light emitted from the light emitting means attenuates within the interior of the seal member, in addition, the structure becomes complicated. However, by using the structure(s) according to the present invention, it is possible to let a water proof gasket to emit light simply and uniformly.

### INDUSTRIAL APPLICABILITY

A water proof structure according to the present invention can provide a device with water proof property and also a uniform illumination function. In particular, the water proof structure of the present invention can be mounted as a water proof means for small mobile type electronic devices such as cellular phone, smart phone and can also give design extensibility.

It is noted that a part(s) or all of the above mentioned exemplary embodiments may be also stated as the following modes, albeit in a non-limiting way.

### (Mode 1)

A water proof structure in which a water proof gasket is arranged between a housing case and a housing cover, wherein the water proof gasket is made of a light permeable material; and
wherein at least one light entrance portion is arranged to respective sides opposing each other, of the water proof gasket; and
at least one portion of the water proof gasket is exposed to outside of the housing.

### (Mode 2)

In said water proof structure, it is preferred that a cross sectional shape of the light entrance portion provides at least one of an upper slant surface and a lower slant surface relative to a traveling direction of light.

### (Mode 3)

In said water proof structure, it is preferred that a slant angle of the upper slant surface has 30 to 60 degrees relative to a plane of light entering into the light entrance portion.

### (Mode 4)

In said water proof structure, it is preferred that a slant angle of the lower slant surface has 30 to 60 degrees relative to a plane of light entering into the light entrance portion.

### (Mode 5)

In said water proof structure, it is preferred that a cross sectional shape of the portion exposed to outside of the housing, of the water proof gasket is a semi-circular shape.

### (Mode 6)

In said water proof structure, it is preferred that the water proof structure provides a reflection portion at a bend portion of the water proof gasket.

### (Mode 7)

In said water proof structure, it is preferred that the water proof structure further provides a water pressure sensor.

The disclosure of the above Patent Literature of Citation List is incorporated herein by reference thereto. Modifications and adjustments of the exemplary embodiment(s) or example(s) are possible within the extent of the overall disclosure (including the claims) of the present invention and based on the basic technical concept of the present invention. Various combinations and selections of various disclosed elements (including each element of each claim, each element of each exemplary example, each element of each drawing, etc.) are possible within the extent of the overall disclosure of the present invention. That is, the present invention of course includes various variations and modifications that could be made by those skilled in the art according to the overall disclosure including the claims and the technical concept. Particularly, as to values and numerical ranges disclosed herein, those are disclosed as a representative example of any value included in the numerical range, and it should be interpreted that any values or subranges falling within the disclosed range are also concretely disclosed even without specific recital thereof.

### REFERENCE SIGNS LIST

- 1, 11, 101: water proof structure
- 2, 12, 102: housing cover
- 2a, 12a: top surface
- 12b: side surface
- 3, 103: water proof gasket (seal member)
- 3a: top surface
- 3b: bottom surface
- 3c: side surface of light emitting portion
- 3d: side surface
- 3g: light emitting portion
- 3i: light entrance portion
- 3j: reflection portion
- 3k: upper slant surface of the light entrance portion
- 31: lower slant surface of the light entrance portion
- 4, 14, 104: housing case
- 4a, 14a: bottom surface
- 4b, 14b: outer side surface
- 4c, 14c: inner side surface
- 4d, 14d: light entrance portion fitting groove
- 5, 105: light emitting means
- 6: water pressure sensor

## Claims

1. A water proof structure in which a water proof gasket is arranged between a housing case and a housing cover, wherein the water proof gasket is made of a light permeable material; and
wherein at least one light entrance portion is arranged to respective sides opposing each other, of the water proof gasket; and
at least one portion of the water proof gasket is exposed to outside of the housing.

2. The water proof structure according to claim 1, wherein a cross sectional shape of the light entrance portion provides at least one of an upper slant surface and a lower slant surface relative to a traveling direction of light.

3. The water proof structure according to claim 2, wherein a slant angle of the upper slant surface has 30 to 60 degrees relative to a plane of light entering into the light entrance portion.

4. The water proof structure according to claim 2 or 3, wherein a slant angle of the lower slant surface has 30 to 60 degrees relative to a plane of light entering into the light entrance portion.

5. The water proof structure according to any one of claims 1 to 4, wherein a cross sectional shape of the portion exposed to outside of the housing, of the water proof gasket is a semi-circular shape.

6. The water proof structure according to any one of claims 1 to 5, wherein the water proof structure provides a reflection portion at a bend portion of the water proof gasket.

7. The water proof structure according to any one of claims 1 to 6, wherein the water proof structure further provides a water pressure sensor.
